# EUROPEAN PATENT SPECIFICATION

(11) **EP 4 067 978 B1**
(45) Date of publication and mention of the grant of the patent: **16.04.2025**
(21) Application number: 20892959.6
(22) Date of filing: 01.07.2020
(51) Int. Cl.: G02B 27/12, B23K 26/064, G02B 6/42, G02B 27/09

(54) **BEAM COUPLING DEVICE, AND LASER PROCESSING MACHINE**
STRAHLKOPPELVORRICHTUNG UND LASERBEARBEITUNGSMASCHINE
DISPOSITIF DE COUPLAGE DE FAISCEAUX ET MACHINE DE TRAITEMENT AU LASER

(30) Priority: 28.11.2019 JP 2019215502
(43) Date of publication of application: 05.10.2022
(73) Proprietor: Panasonic Holdings Corporation, Osaka 571-8501 (JP)
(72) Inventor: ASAI, Yosuke, Osaka 540-6207 (JP); ICHIHASHI, Kouki, Osaka 540-6207 (JP)
(74) Representative: Eisenführ Speiser
(86) International application number: PCT/JP2020/025874
(87) International publication number: WO 2021/106256

(56) References cited:
- EP-A1- 3 506 437
- WO-A1-2018/037663
- WO-A1-2019/163335
- JP-A- 2000 019 362
- JP-A- 2015 192 079
- JP-A- H11 156 567
- US-A1- 2008 101 429
- US-A1- 2019 028 082

## Description

### TECHNICAL FIELD

The present disclosure relates to a beam coupling device and a laser processing machine provided with the beam coupling device.

### BACKGROUND ART

Patent Document 1 discloses a wavelength beam combining laser system in which individual light beams are superposed to form a coupling beam.
Patent Document 1 discloses that light beams from a plurality of diode bars are condensed on an optical fiber from the viewpoint of increasing light outputs. Further, for the purpose of reducing the size of the laser system, an optical system for removing arrangement of a coupling lens in wavelength beam combining from a focal length is separately included, and a beam rotor is rotated.
Patent Document 2 discloses laser modules using two-dimensional laser diode arrays are combined to provide an intense laser beam. The laser diodes in a two-dimensional array are formed into rows and columns, and an optical assembly images light generated by laser diodes in a column into an optical fiber. The laser light outputs of the laser modules are combined by a spectral combiner into an optical fiber to form an intense laser beam.

### CITATION LIST

### PATENT DOCUMENTS

Patent Document 1: US 2016/0048028 A1
Patent Document 2: US 2008/0101429 A1

### SUMMARY

The present disclosure provides a beam coupling device capable of coupling a plurality of light beams at high density, and a laser processing machine including the beam coupling device.

The beam coupling device according to the present disclosure includes a light source, a plurality of optical units, and a coupling optical system. The light source includes a plurality of light emitters arranged in a first direction and a second direction, to emit a plurality of light beams having a light ray direction from each of the light emitters, wherein the first direction and the second direction intersect each other and the light ray direction intersects the first and second directions. The plurality of optical units are arranged to guide each light beam for each set of light emitters arranged in the first direction in the light source. The coupling optical system is arranged to couple the plurality of light beams guided by each of the optical units. Each of the optical units is arranged to direct outward the light ray direction of the light beam from a light emitter that is located outside in the first direction for the set of light emitters, to guide the light beam from the light emitter into the coupling optical system.

The laser processing machine according to the present disclosure includes the above-mentioned beam coupling device and a processing head arranged to irradiate a workpiece with a light beam coupled by the beam coupling device.

According to the beam coupling device and the laser processing machine according to the present disclosure, a plurality of light beams can be coupled at high density in the beam coupling device.

### BRIEF DESCRIPTION OF THE DRAWINGS

FIG. 1 is a block diagram illustrating a configuration of a laser processing machine according to a first embodiment of the present disclosure.
FIGS. 2A and 2B are diagrams illustrating an overall configuration of a beam coupling device according to the first embodiment.
FIGS. 3A and 3B are diagrams explaining directing outward of an outer chief ray in the beam coupling device.
FIGS. 4A and 4B are diagrams illustrating a coupling optical system in a beam coupling device.
FIG. 5 is a diagram illustrating a focal length of a cylindrical lens of a coupling optical system.
FIGS. 6A and 6B are diagrams illustrating a basic configuration of an optical unit in a beam coupling device.
FIG. 7 is a perspective view illustrating a configuration example of a beam twister unit in the optical unit.
FIG. 8 is a diagram illustrating a configuration example of the optical unit in the beam coupling device of the first embodiment.
FIGS. 9A to 9C are optical path diagrams illustrating a chief ray in the optical unit of FIG. 8.
FIG. 10 is a diagram illustrating a first configuration example of an outer optical unit in the beam coupling device.
FIG. 11 is a diagram illustrating a second configuration example of an outer optical unit in the beam coupling device.
FIG. 12 is a diagram illustrating an example of the beam coupling device of the first embodiment.
FIG. 13 is a diagram illustrating a configuration example of an optical unit in a beam coupling device of a second embodiment.
FIG. 14 is a cross-sectional view of the optical unit of FIG. 13.
FIGS. 15A to 15C are optical path diagrams illustrating a chief ray in the optical unit of FIG. 13.
FIG. 16 is a diagram illustrating an example of the beam coupling device of the second embodiment.
FIGS. 17A and 17B are diagrams illustrating a modification of a beam coupling device.

### DESCRIPTION OF EMBODIMENTS

Hereinafter, embodiments will be described in detail with reference to the drawings as appropriate. However, more detailed explanation than necessary may be omitted. For example, detailed explanations of already well-known matters and duplicate explanations for substantially the same configuration may be omitted. This is to avoid unnecessary redundancy of the following description and to facilitate the understanding of those skilled in the art.

It should be noted that the applicant provides the accompanying drawings and the following description in order for those skilled in the art to fully understand the present disclosure, and does not intend to limit the subject matter described in the claims.

### (First Embodiment)

In the first embodiment, a beam coupling device for spatial beam combining and a laser processing machine provided with the beam coupling device will be described.

### 1. Laser processing machine

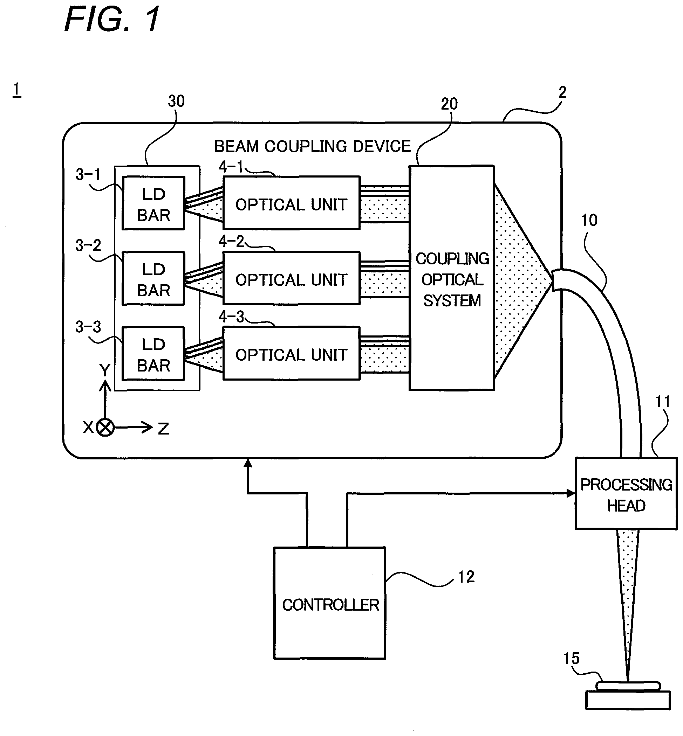

The laser processing machine according to the first embodiment will be described with reference to FIG. 1.

FIG. 1 is a diagram illustrating a configuration of a laser processing machine 1 according to the present embodiment. For example, the laser processing machine 1 includes a beam coupling device 2, a transmission optical system 10, a processing head 11, and a controller 12. The laser processing machine 1 is a device that irradiates various workpieces 15 with laser light to perform various laser processing. For example, the various laser processing include laser welding, laser cutting, and laser perforation.

In the present embodiment, the beam coupling device 2 includes a laser light source 30, a plurality of optical units 4-1 to 4-3, and a coupling optical system 20. The laser light source 30 includes a plurality of LD bars 3-1 to 3-3 in the present embodiment. Hereinafter, the generic term for LD bars 3-1 to 3-3 may be referred to as "LD bar 3", and the generic term for optical units 4-1 to 4-3 may be referred to as "optical unit 4".

The LD bar 3 is formed of an array of light emitters including a plurality of LDs (laser diodes) arranged one-dimensionally. The plurality of LD bars 3 are juxtaposed in the beam coupling device 2 in a direction orthogonal to the arrangement direction, with the arrangement direction of each LD oriented in parallel, for example. The number of LD bars 3 in the beam coupling device 2 is not particularly limited to three as the shown example, and may be two or four or more.

Hereinafter, the direction in which the plurality of LDs are arranged in the LD bar 3 is referred to as "X direction", and the direction in which the plurality of LD bars 3-1 to 3-3 are arranged is referred to as "Y direction", and the direction orthogonal to the X and Y directions is referred to as "Z direction".

The beam coupling device 2 of the present embodiment is a device that performs spatial beam coupling in which a large number of light beams emitted by each LD of the plurality of LD bars 3 spatially arranged in the laser light source 30 are coupled, to supply the laser light of the laser processing machine 1, for example. In the present embodiment, the beam coupling device 2 capable of performing beam coupling at a high density with a small beam diameter is provided.

In the beam coupling device 2 of the present embodiment, a plurality of optical units 4 are provided for the number of LD bars 3, for example. One optical unit 4 is an optical system that guides a light beam from each LD in one LD bar 3 to the coupling optical system 20. The coupling optical system 20 is an optical system that couples the light beams from each optical unit 4 in the beam coupling device 2. The beam coupling device 2 will be described later.

In the laser processing machine 1, the transmission optical system 10 includes e.g. an optical fiber arranged so that a light beam coupled by the coupling optical system 20 is incident, to transmit the laser light from the beam coupling device 2 into the processing head 11. The processing head 11 is a device that is arranged to face the workpiece 15 to irradiate the workpiece 15 with a laser light transmitted from the beam coupling device 2, for example.

The controller 12 is a control device that controls the overall operation of the laser processing machine 1. The controller 12 includes, for example, a CPU or MPU that cooperates with software to realize a predetermined function. The controller 12 includes an internal memory such as a flash memory for storing various programs and data. The controller 12 may be provided with various interfaces that can input oscillation conditions and the like by the operation of the user. Further, the controller 12 may be provided with a hardware circuit such as an ASIC or FPGA that realizes various functions. Further, the controller 12 may be integrally configured with a drive circuit of the laser light source 30.

### 2. Beam coupling device

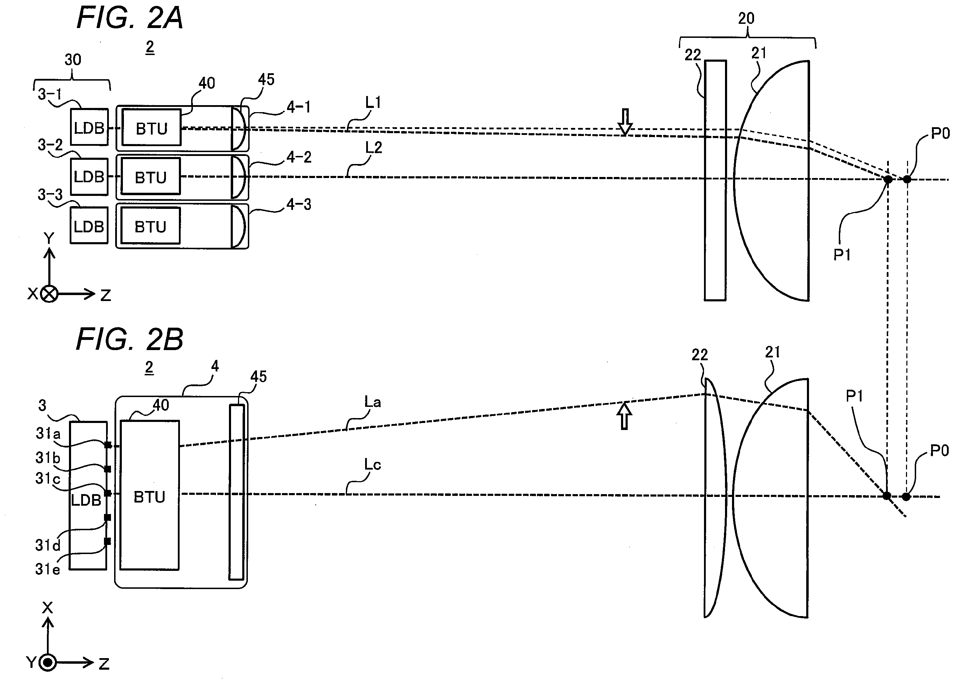

The beam coupling device 2 according to the present embodiment will be described with reference to FIGS. 2A and 2B.

FIGS. 2A and 2B are diagrams illustrating the overall configuration of the beam coupling device 2. FIG. 2A illustrates a side view of the beam coupling device 2 as viewed from the X direction. FIG. 2B illustrates a plan view of the beam coupling device 2 as viewed from the Y direction.

In the beam coupling device 2 of the present embodiment, for example, as illustrated in FIG. 2A, respective LD bars 3 are arranged on the -Z side of different optical units 4. Each optical unit 4 includes a BTU (beam twister unit) 40 arranged opposite to the LD bar 3, and a SAC (slow axis collimator) 45 arranged on the +Z side of the BTU 40. The coupling optical system 20 is arranged on the +Z side of the optical unit 4 and includes an axially symmetric condenser lens 21 and a cylindrical lens 22 arranged between the condenser lens 21 and the optical unit 4.

FIG. 2B exemplifies the five LD 31a, 31b, 31c, 31d, and 31e in the LD bar 3. The number of LDs 31a to 31e contained in one LD bar 3 is e.g. tens to hundreds. The plurality of LDs 31a to 31e in the LD bar 3 are an example of a set of light emitters in the laser light source 30 of the present embodiment. Hereinafter, the generic term of LDs 31a to 31e may be referred to as "LD 31". Each LD 31 constitutes the emitter of the LD bar 3 to emit a light beam to the +Z side.

FIGS. 2A and 2B exemplify a beam coupling position P1 resulted from coupling the light beam by the beam coupling device 2. The beam coupling position P1 is set to a position at which a beam diameter including the light beam emitted from each of the LDs 31a to 31e of all the LD bars 3-1 to 3-3 is minimized, for example. For example, an incident end of the optical fiber of the transmission optical system 10 described above is arranged at the beam coupling position P1.

FIG. 2A exemplifies a chief ray L1 of the light beam from the outer LD bar 3-1 in the Y direction and a chief ray L2 of the light beam from the central LD bar 3-2. FIG. 2B exemplifies a chief ray La of the light beam from the outer LD 31a in the X direction and a chief ray Lc of the light beam from the central LD 31c. In the beam coupling device 2 of the present embodiment, for example, the central LD 31c in the X and Y directions travels straight through the opposing optical unit 4 and the coupling optical system 20 and has a chief ray Lc parallel to the Z direction.

In the present embodiment, as illustrated in FIG. 2A, the optical unit 4 is configured such that the chief ray L1 of the light beam emitted by the outer LD bars 3-1 of the plurality of LD bars 3 arranged in the Y direction is directed inward, in view of increasing the output of the beam coupling device 2 for spatial beam combining, for example (details will be described later). For example, the upper (+Y side) optical unit 4 in the drawing makes the chief ray L1 of the light beam inclined from the Z direction to the lower side (-Y side). In this case, the beam coupling position P1 in the Y direction where the chief rays L1 and L2 intersect between the LD bars 3 is located on the -Z side from a focal position P0 of the condenser lens 21.

On the other hand, as illustrated in FIG. 2B, in a plurality of LDs 31a to 31e arranged in the X direction for each LD bar 3, the beam coupling device 2 of the present embodiment is configured to make the chief ray La of the light beam from the outer LD 31a directed outward. As a result, as will be described in detail later, the beam diameter itself at the coupling of each light beam can be reduced, and the density of the light beam incident on the coupling optical system 20 can be increased. Further, in order to match the beam coupling position P1 in the X direction and the Y direction, the beam coupling device 2 of the present embodiment uses a cylindrical lens 22 for the coupling optical system 20. Hereinafter, the details of the beam coupling device 2 will be described.

### 2-1. Details of beam coupling device

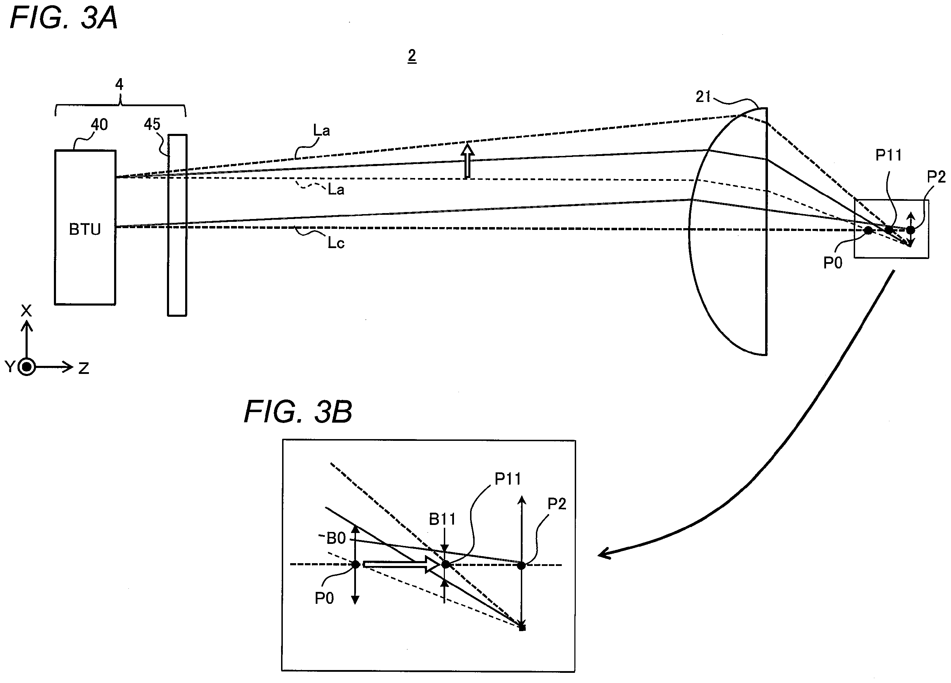

First, in the beam coupling device 2 of the present embodiment, the action effect of outwardly directing the outer chief ray La in the X direction when the cylindrical lens 22 is not used will be described with reference to FIGS. 3A and 3B.

FIG. 3A illustrates optical paths of various light rays in the beam coupling device 2 without the cylindrical lens 22. The various light rays include the chief rays La and Lc and peripheral rays thereof as in FIG. 2B.

FIG. 3A exemplifies an optical path before and after the outer chief ray La in the X direction is directed outward. Further, for example, an optical image of the surface on the +Z side of the BTU 40 exemplifies an image formation position P2 at which an image is formed by the condenser lens 21. At the image formation position P2, the beam diameter per LD 31 is the minimum. On the other hand, the beam diameters of the entire light beams of the plurality of LDs 31a to 31e are the minimum at the positions at which the chief rays intersect each other.

According to the beam coupling device 2 of the present embodiment, by directing outward the chief ray La of the light beam from the outer LD 31a, a position P11 at which the chief rays La and Lc intersect becomes the +Z side from the focal position P0. That is, the intersection position P11 of the chief rays La and Lc can be closer to the image formation position P2 by the directing outward of the outer chief ray La.

FIG. 3B illustrates an enlarged view of a region in the vicinity of the focal position P0 of the condenser lens 21 in FIG. 3A. At the focal position P0 of the condenser lens 21, a beam diameter B0 of each LD 31 is larger than the image formation position P2 as far from the image formation position P2. In contrast to this, at the intersection position P11 with the chief ray La bring directed outward, the smaller beam diameter B11 can be obtained for each LD 31 as closer to the image formation position P2 than the focal position P0.

Therefore, according to the beam coupling device 2 of the present embodiment, the beam diameter at the coupling can be reduced not only in view of combining a plurality of light beams but also view of individual light beams. As a result, high-density beam coupling can be realized and beam quality can be improved.

Here, a new problem is found that the intersection position P11 illustrated in FIGS. 3A and 3B is on the +Z side of the focal position P0 of the condenser lens 21, resulting in deviating from the beam coupling position P1 (refer to Fig. 2A) for the outer chief ray directed inward in the Y direction. Therefore, in the present embodiment, the cylindrical lens 22 having a positive refractive power only in the X direction is used for the coupling optical system 20 to resolve the non-alignment between the X and Y directions.

### 2-1-1. Coupling optical system

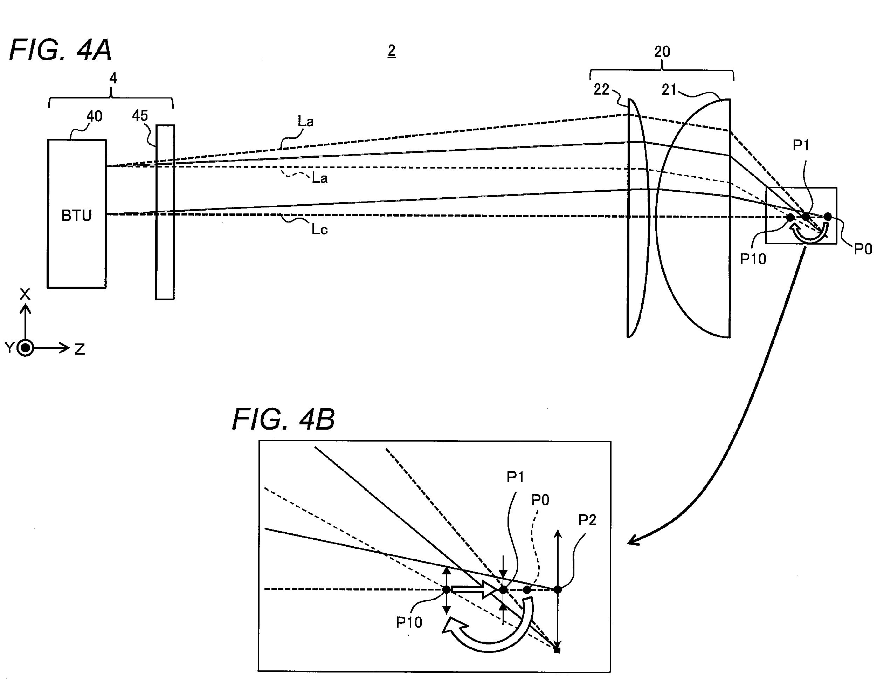

FIGS. 4A and 4B is a diagram illustrating the action and effect of the cylindrical lens 22 of the coupling optical system 20 in the beam coupling device 2 of the present embodiment. FIGS. 4A and 4B illustrate, in the beam coupling device 2 including the cylindrical lens 22, the optical paths of the chief rays La and Lc similar to those in FIGS. 3A and 3B.

As illustrated in FIGS. 4A and 4B, according to the cylindrical lens 22, the focal position P10 of the entire coupling optical system 20 is -Z side of the focal position P0 of the condenser lens 21 in the X direction. In this case, the beam coupling position P1, which is the position at which the outer chief rays La and Lc when being directed outward in the X direction intersect each other, is on the +Z side from the above focal position P10, instead of the focal position P0 of the condenser lens 21 in the examples of FIGS. 3A and 3B. Therefore, it is possible to bring the beam coupling position P1 closer to the image formation position P2 within the range on the -Z side from the focal position P0 of the condenser lens 21 and reduce the beam diameter in the same manner as in the above example.

Further, as the cylindrical lens 22 does not have a refractive power in the Y direction, the cylindrical lens 22 does not particularly prevent the chief ray L1 from being directed inward outside in the Y direction as illustrated in FIG. 2A. Therefore, the beam coupling position P1 in the Y direction can be maintained on the -Z side from the focal position P0 of the condenser lens 21 regardless of the presence or absence of the cylindrical lens 22. Therefore, according to the coupling optical system 20 of the present embodiment, according to the refractive power in the X direction larger than the Y direction, the beam coupling position P1 can be aligned in the X direction and the Y direction as illustrated in FIGS. 2A and 2B.

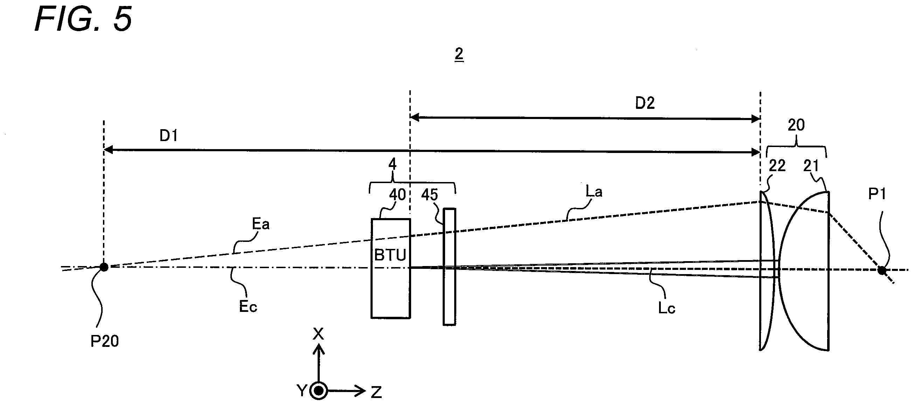

FIG. 5 is a diagram illustrating a focal length D2 of the cylindrical lens 22. In the coupling optical system 20 of the present embodiment, the cylindrical lens 22 has a relatively long focal length D2, e.g. equal to or more than the focal length of the condenser lens 21. For example, the focal length D2 of the cylindrical lens 22 may be shorter than a distance D1 to the cylindrical lens 22 from the position P20 at the intersection of an extension line Ea of the chief ray La directed outward in the X direction toward the -Z side and an extension line Ec of the central chief ray Lc. The extension line Ec corresponds to the optical axis of the condenser lens 21, for example.

Based on the focal length D2 as described above, the refractive power of the cylindrical lens 22 may be sufficient to direct inward the chief ray La when emitted to the condenser lens 21 after incident on the cylindrical lens 22 in a state where the outer chief ray La in the X direction is directed outward. According to the refractive power, the chief rays La and Lc can intersect each other on the -Z side from the focal position P0 of the condenser lens 21. The distance between the cylindrical lens 22 and the BTU 40 may be set to the focal length D2 of the cylindrical lens 22.

In the above description, an example in which the cylindrical lens 22 is used for the coupling optical system 20 has been described, but the cylindrical lens 22 does not necessarily have to be used. For example, various optical systems having a positive refractive power in the X direction larger than a refractive power in the Y direction may be adopted in the coupling optical system 20. For example, in the case where the entire coupling optical system 20 has the refractive power in the X and Y directions same as the configuration of FIGS. 2A and 2B, the beam coupling position P1 in the X and Y directions can be aligned in the same manner as described above.

### 2-2. Optical unit

Hereinafter, the details of the optical unit 4 of the beam coupling device 2 in the present embodiment will be described.

### 2-2-1. Basic configuration of optical unit

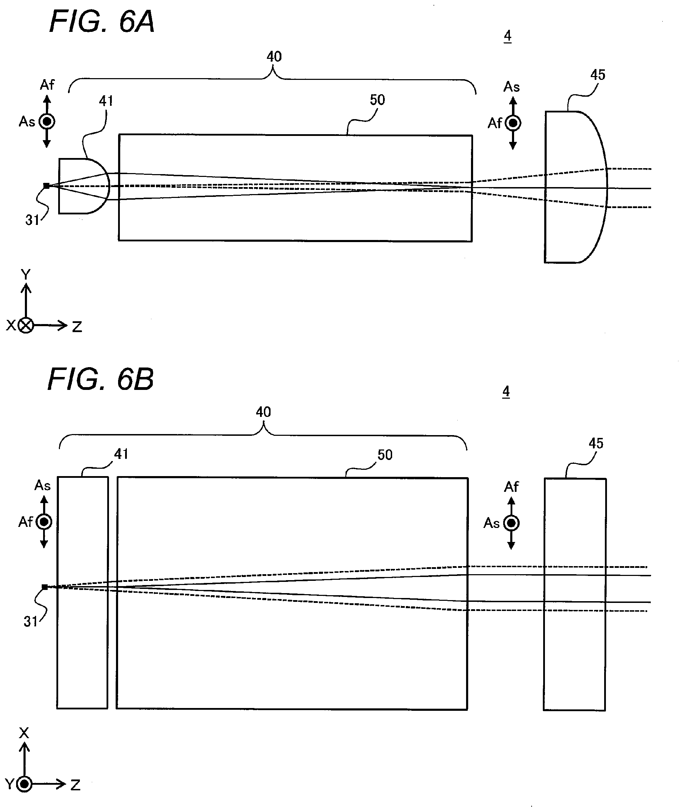

First, the basic configuration of the optical unit 4 will be described with reference to FIGS. 6A to 7. FIGS. 6A and 6B illustrate the basic configuration of the optical unit 4.

FIG. 6A illustrates a plan view of the optical unit 4 in the basic configuration. FIG. 6B illustrates a side view of the optical unit 4 of FIG. 6A. FIGS. 6A and 6B illustrate the optical path of the light beam from one LD 31.

The BTU 40 in the optical unit 4 includes a BT (beam twister) 50 and a FAC (fast axis collimator) 41. In the optical unit 4, the FAC 41, the BT 50, and the SAC 45 are arranged in order from the vicinity of LD 31 to the +Z side, for example.

In the present embodiment, the LD 31 emits a light beam having a fast axis Af and a slow axis As. In the fast axis Af of the light beam, the beam diameter expands more rapidly than the slow axis As, and it is easier to obtain high beam quality. Before the light beam of LD 31 is incident on the optical unit 4, the fast axis Af of the light beam is directed in the Y direction and the slow axis As is directed in the X direction.

The FAC 41 is provided for collimating a light beam on the fast axis Af, and is formed of a cylindrical lens having a positive refractive power, for example. For example, the FAC 41 is arranged with the longitudinal direction being the X direction, as illustrated in FIGS. 6A and 6B. In this example, the light beam from LD 31 is collimated by the FAC 41 in the Y direction (i.e., the fast axis Af) and is incident on the BT 50.

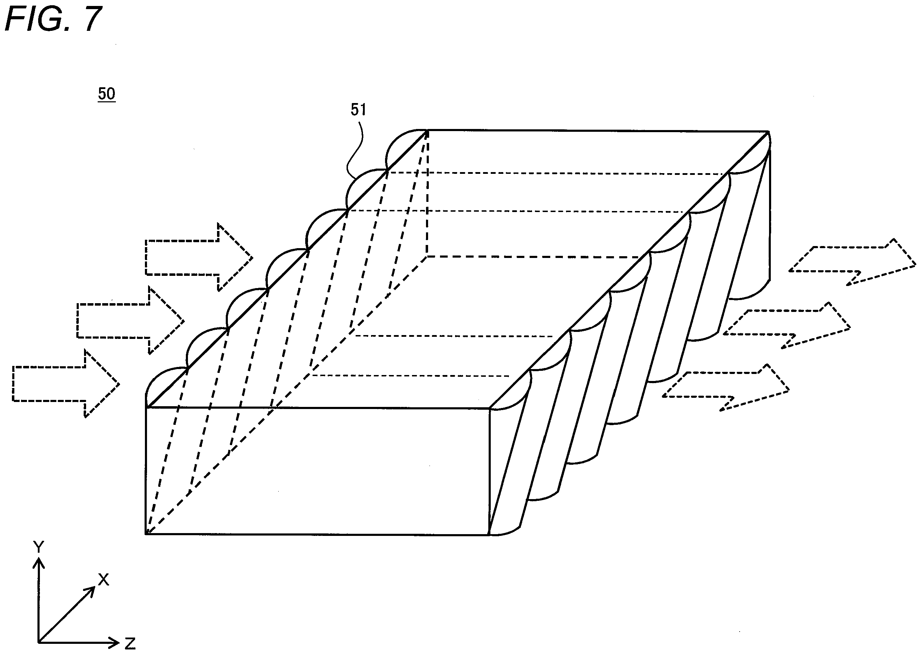

FIG. 7 illustrates a configuration example of the BT 50. For example, the BT 50 is an optical element that rotates a plurality of light beams, respectively, and the BT 50 includes a plurality of oblique lens portions 51. The oblique lens portion 51 is a portion of the BT 50 that constitutes a lens for each LD 31, and constitutes e.g. a cylindrical lens. The BT 50 is formed so as to arrange a plurality of oblique lens portions 51 at a predetermined pitch in the longitudinal direction, for example. The oblique lens portion 51 is inclined by 45° with respect to both the arrangement direction and the thickness direction of the BT 50, for example. The pitch of the oblique lens portion 51 is the same as the pitch between the LDs 31 in the LD bar 3, for example.

In the example of FIGS. 6A and 6B, the BT 50 rotates the light beam incident from the LD 31 through the FAC 41 by a rotation angle of 90° in the XY plane. As a result, the slow axis As of the light beam emitted from the BT 50 is oriented in the Y direction, and the fast axis Af is oriented in the X direction. The light beam emitted from the BT 50 is divergent light in the Y direction and parallel light in the X direction.

The SAC 45 is provided for collimating a light beam on the slow axis As, and is formed of a cylindrical lens having a positive refractive power, for example. As illustrated in FIGS. 6A and 6B, the SAC 45 is arranged with the longitudinal direction being the X direction, for example. In this example, the light beam from the BT 50 is collimated by the SAC 45 in the Y direction (i.e., the slow axis As) and then exits from the optical unit 4.

According to the above optical unit 4, the light beam emitted from each LD 31 of the LD bar 3 is basically collimated in the fast axis Af and the slow axis As. However, due to the wave characteristics of light, the beam diameter at the coupling may widen by an influence of waves from the +Z side surface of the BT 50, particularly in the fast axis Af. To address this, the optical unit 4 of the present embodiment makes possible to reduce the above-mentioned influence and reduce the beam diameter by the outward direction of the outer chief ray in the X direction and the coupling optical system 20.

In the present embodiment, the directing outward and inward of various chief rays are realized by utilizing the basic functions of each portion of the optical unit 4 as described above. Hereinafter, a configuration example of such an optical unit 4 will be described.

### 2-2-2. Configuration directing outward in X direction

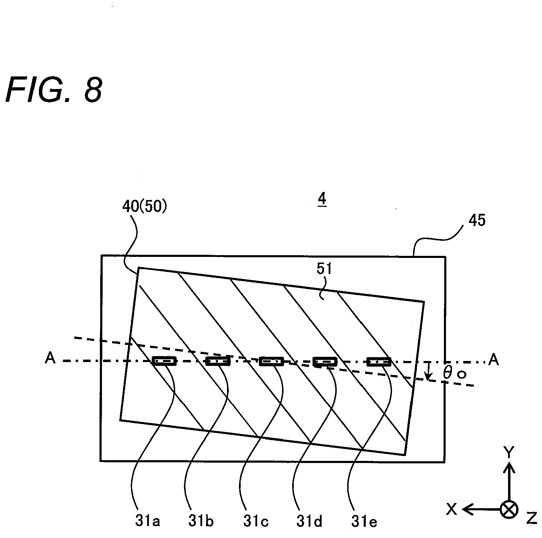

FIG. 8 illustrates a configuration example of the optical unit 4 in the beam coupling device 2 of the present embodiment. FIG. 8 illustrates a front view of the optical unit 4 as viewed from the -Z side, together with LDs 31a to 31e.

In the beam coupling device 2 of the present embodiment, each optical unit 4 is configured as illustrated in FIG. 8 from the viewpoint of outwardly directing each of the outer chief rays in the X direction, for example. In the optical unit 4 of the present embodiment, the BTU 40 is arranged so as to rotate the longitudinal direction from the X direction by a predetermined rotation angle θo with the position at which the chief ray of the central LD 31c passes on the XY plane as the rotation axis (e.g., 0.001° ≤ θo ≤ 1°). The orientation of the rotation angle θo is defined clockwise in the drawing, as an orientation causing an angle, at which the extending direction of the cylindrical lens 22 in the BT 50 is inclined with respect to the X direction, to be large. The rotation angle θo may be common among the plurality of optical units 4 or may be set separately.

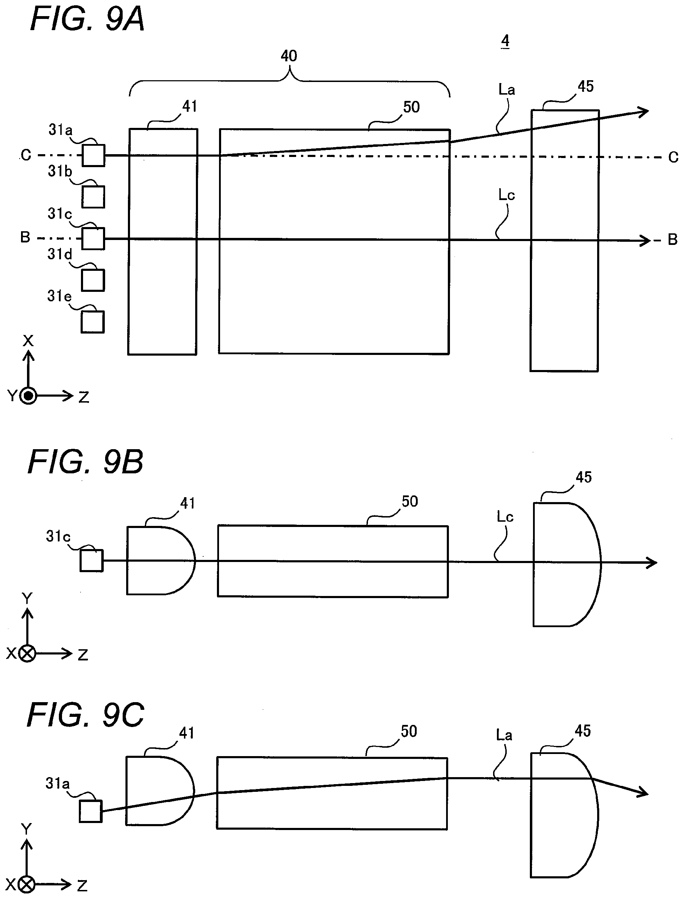

FIGS. 9A to 9C exemplify the optical path in the optical unit 4 of this configuration example. FIG. 9A corresponds to the A-A cross section in the optical unit 4 of FIG. 8. The A-A cross section is an XZ plane in which each LDs 31a to 31e of the LD bar 3 is located. FIGS. 9B and 9C correspond to the B-B cross-sectional view and the C-C cross-sectional view in FIG. 9A, respectively. The B-B cross section is the YZ plane where the central LD 31c is located. The C-C cross section is the YZ plane where the outer LD 31a is located.

In the optical unit 4 of this configuration example, the positional relation between the LD 31a and the BTU 40 deviates as much as the LD 31a away from the center in the X direction (FIG. 9A) according to the rotation angle θo of the BTU 40 in the XY plane (FIGS. 9B and 9C). Therefore, for example, as illustrated in FIG. 9C, the chief ray La of the outer LD 31a has an inclination from the Z direction to the Y direction when emitted from the FAC 41.

The light beam from LD 31 rotates in the BT 50 by 90° in the XY plane. Therefore, the inclination of the chief ray La of the outer LD 31a is converted into the inclination in the X direction, for example, as illustrated in FIG. 9A. Consequently, as the LD 31 is located on the more outside, the chief ray can be directed more outward in the X direction according to the rotation angle θo of the BTU 40. As illustrated in FIG. 9C, since the positional relationship between the BTU 40 and the SAC 45 deviates with respect to the outer LD 31a, the chief ray La can be inclined in the Y direction after being emitted from the SAC 45. However, such an inclination can be kept slight.

### 2-2-3. Configuration directing inward in Y direction

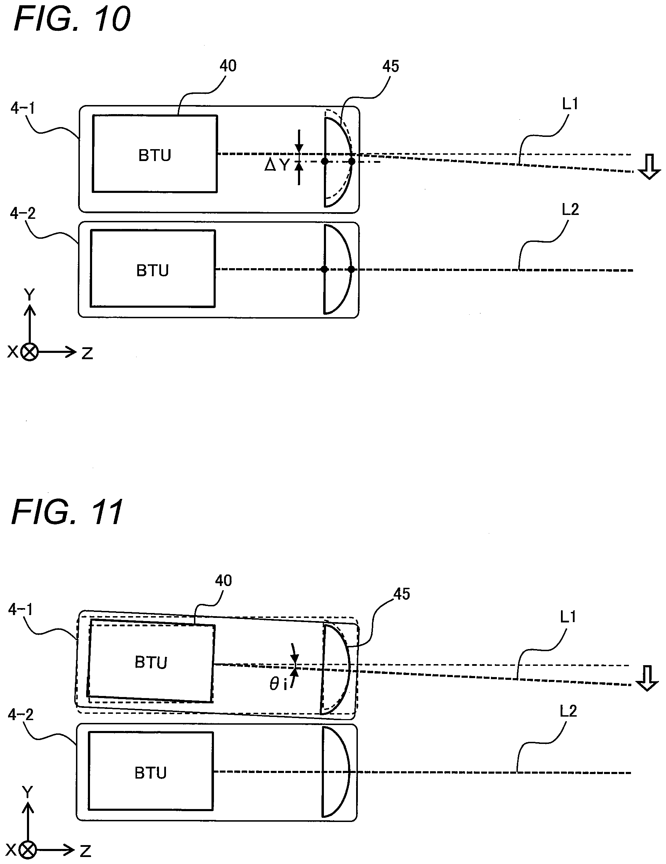

In the beam coupling device 2 of the present embodiment, in addition to the above configuration, the optical unit 4-1 corresponding to the outer LD bar 3-1 is partially modified from the above-mentioned basic configuration from the viewpoint of allowing the outer chief ray L1 to be directed inward in the Y direction. Such a configuration example will be described with reference to FIGS. 10 and 11.

FIG. 10 illustrates first configuration example of the outer optical unit 4-1 in the Y direction. In this configuration example, at the outer optical unit 4 in the Y direction (e.g., +Y side), the SAC 45 is arranged to shift inward (e.g., -Y side) by a predetermined shift width ΔY from the same position as the central optical unit 4. As a result, the chief ray L1 can be shifted from the optical axis collimating the light beam incident on by the SAC 45, and the light beam emitted from the outer optical unit 4-1 can be directed inward. The shift width ΔY defines the width of shifting the optical axis of the SAC 45 from the position at which the chief ray L1 is incident on the SAC 45, according to the degree to which the chief ray L1 is directed inward.

By directing the chief ray L1 from the outer optical unit 4-1 inward, as illustrated in FIG. 2A, the distance between the chief rays L1 and L2 arriving at the condenser lens 21 from the plurality of optical units 4-1 and 4-2 is smaller than the distance between the optical units 4-1 and 4-2. Therefore, the number of optical units 4 and LD bars 3 to be spatially synthesized by the condenser lens 21 can be increased, and the light output by spatial synthesis can be increased in the beam coupling device 2.

In the case of increasing the number of optical units 4, the shift width ΔY is set as large as the outer optical unit 4, for example. As a result, the inclination at which the chief ray is directed inward is increased by the optical unit 4 located on the outside in the Y direction so that the positions at which the chief rays intersect each other are matched.

The configuration in which the outer chief ray L1 in the Y direction is directed inward is not limited to the above configuration example. FIG. 11 illustrates a second configuration example of the outer optical unit 4-1 in the Y direction. In this configuration example, the outer optical unit 4-1 in the Y direction is arranged to be inclined inward by a predetermined inclination angle θi in the YZ plane from the same direction as the central optical unit 4. The inclination angle θi is appropriately set according to the degree to which the chief ray L1 is directed inward.

Also in the above second configuration example, the light beam emitted from the outer optical unit 4-1 can be directed inward as in the first configuration example. In the optical unit 4-1, the SAC 45 may not be inclined, but only the BTU 40 may be inclined. Further, the LD bar 3 may or may not be inclined according to, for example, the direction of the corresponding optical unit 4.

### 2-3. Examples of First Embodiment

Examples relating to the configuration example of the beam coupling device 2 of the present embodiment as described above will be described below.

As a numerical example of the beam coupling device 2 of the present embodiment, numerical simulations of each of the configuration examples of FIGS. 10 and 11 were performed. In this simulation, the distance between the plurality of optical units 4 was set to 4.8 mm, the focal length of the SAC 45 was set to 15 mm, and the focal length of the condenser lens 21 was set to 50 mm.

As a simulation of FIG. 10, the shift width ΔY of the SAC 45 was set to "ΔY = 0.0560 mm". Then, it was checked that the outer chief ray L1 in the Y direction is directed inward at intervals of 1.5 mm when reaching the coupling optical system 20.

Furthermore, in this simulation, the rotation angle θo of the BT 50 was set to "θo = 0.01°". In this case, by using a cylindrical lens 22 having a focal length of 500 mm for the coupling optical system 20, the effect of aligning the beam coupling position P1 between the X and Y directions was checked.

Further as the simulation of FIG. 11, in the same simulation environment as above, the inclination angle θi of the optical unit 4 was set to "θi = 0.18°" together with "ΔY = 0". In such a simulation, the same effect as above was checked.

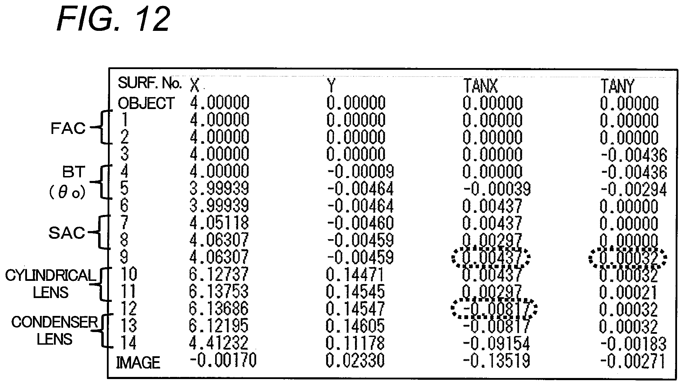

FIG. 12 illustrates the simulation results of the beam coupling device 2 of the present embodiment. In this simulation, in order to check the effect of the rotation angle θo (= 0.01°) of the BTU 40 with the same settings as above, the numerical calculation of the chief ray on the +X side was performed. Each row in the drawing shows the numerical calculation result for each surface number from the object side (i.e., -Z side) to the image side (i.e., +Z side) with the chief ray passing through each portion of the beam coupling device 2. As a numerical calculation result, "X" represents an X coordinate, "Y" represents a Y coordinate, "TANX" represents an inclination in the XZ plane with a tan function, and "TANY" represents an inclination in the YZ plane with the tan function. The position of LD 31 corresponding to the numerically calculated chief ray was 4 mm in the X coordinate.

According to the simulation results in FIG. 12, "TANX" was changed from a zero value at the emission by the LD 31 to a positive value "0.00437" after the exit of the SAC 45, indicating that the chief ray on the +X side is directed outward. Further, the value "0.00032" of "TANY" at this time was sufficiently smaller than the above-mentioned "TANX". Therefore, it was checked that the outer chief ray in the X direction can be directed outward in the X direction with keeping the inclination in the Y direction slightly according to the rotation angle θo of the BT 50. It was also checked that the chief ray was directed inward in the X direction after the emission of the cylindrical lens 22.

### 3. Summary

As described above, in the present embodiment, the beam coupling device 2 includes a laser light source 30 which is an example of the light source, a plurality of optical units 4, and a coupling optical system 20. The laser light source 30 includes a plurality of LDs 31 as an example of a plurality of light emitters arranged in the X direction which is an example of the first direction and the Y direction which is an example of a second direction intersecting the first direction. The laser light source 30 emits a plurality of light beams having light ray directions intersecting with the X and Y directions from each LD 31. The light ray direction of each LD 31 is defined by, for example, the chief ray of each light beam. The plurality of optical units 4 guide each light beam for each LD bar 3, which is an example of a set of LDs 31 arranged in the X direction in the laser light source 30. The coupling optical system 20 couples a plurality of light beams guided to each optical unit 4. Each optical unit 4 makes the light ray direction (e.g., the chief ray La) of the light beam directed outward from the LD 31a located outside in the X direction in the LD bar 3, to guide the light beam from each LD 31 into the coupling optical system 20.

According to the above beam coupling device 2, the position at which the chief rays of each LD 31 intersect each other in the X direction can be brought closer to the image formation position from the focal position of the coupling optical system 20. As a result, the beam diameter of the light beam at the coupling can be reduced, and a plurality of light beams can be coupled at a high density. The first and second directions do not have to be perpendicular to each other, and may intersect each other within the allowable error angle range as appropriate.

In the present embodiment, the coupling optical system 20 has a positive refractive power larger in the X direction than that in the Y direction. The plurality of optical units 4 are arranged to direct inward the light ray direction (e.g., the chief ray L1) of the light beams from the LD 31 of the LD bar 3-1 located on the outer side inward, among the LD bars 3-1 and 3-2 containing the plurality of LDs 31 arranged in the Y direction in the laser light source 30.

As a result, the light beam can be supplied to the coupling optical system 20 at a narrower interval than the interval between the optical units 41 in the Y direction, and the output of the beam coupling device 2 can be increased by spatial beam combining. Further, in such a case, the beam coupling position P1 having the minimum beam diameter can be aligned in each of the X and Y directions based on the refractive power of the coupling optical system 20.

In the present embodiment, the coupling optical system 20 includes an axially symmetric condenser lens 21 and a cylindrical lens 22 having a positive refractive power in the X direction. For example, the refractive power of the cylindrical lens 22 can be set to the extent that the light ray direction of the light beam from the outer LD 31a in the X direction is directed from the outward direction at the incident to the directing inward at the emission.

For example, the cylindrical lens 22 has the focal length D2 shorter than the distance D1 to the cylindrical lens 22 from a position P20 at which an extension line Ec of the optical axis of the condenser lens 21 intersects another extension line Ea obtained by extending the chief ray La from the optical unit 4 toward the laser light source 30, the chief ray La corresponding to the light beam directed outward by the optical unit 4. Accordingly, the cylindrical lens 22 can have a refractive power to the extent that the light ray direction of the light beam from the outer LD 31a in the X direction is directed inward at the emission.

In the present embodiment, each optical unit 4 includes a SAC 45, which is an example of a collimator lens arranged to collimate each light beam from the LD 31 of LD bar 3 in the Y direction. For example, as illustrated in FIG. 10, in a plurality of optical units 4-1 and 4-2, the SAC 45 of the optical unit 4-1 located on the outer side in the Y direction is arranged at a position at which the incident light beam is directed inward. As a result, the directing inward of the outer chief ray L1 in the Y direction can be realized.

In the present embodiment, as illustrated in FIG. 10, among the plurality of optical units 4, the optical units 4 located outside in the Y direction may be arranged to direct inward orientation for emitting the light beam incident from the light source, for example. As a result, the directing inward of the outer chief ray L1 in the Y direction can be realized.

In the present embodiment, the optical unit 4 includes a BTU 40 arranged to rotate each light beam from the LD 31 of the LD bar 3. The BTU 40 is arranged at a rotation angle θo with respect to the LD bar 3, the rotation angle θo directing outward the light ray direction of the light beam emitted by the LD 31a located outward in the X direction. As a result, the outward direction of the outer chief ray La in the X direction can be realized.

In the present embodiment, the laser processing machine 1 includes the beam coupling device 2 and the processing head 11 arranged to irradiate a workpiece with a light beam coupled by the beam coupling device 2. In the laser processing machine 1, the plurality of light beams can be coupled at high density by the beam coupling device 2.

### (Second Embodiment)

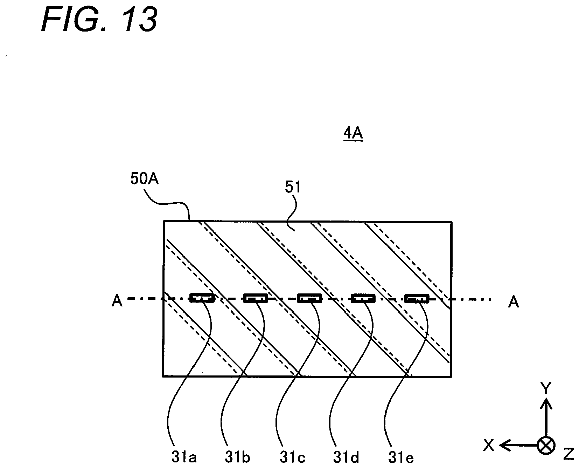

Hereinafter, the second embodiment will be described with reference to FIGS. 13 to 16. In the first embodiment, the outer chief ray La in the X direction is directed outward by the rotation of the BT 50 of the optical unit 4. In the second embodiment, another example of the configuration in which the chief ray La is directed outward will be described.

Hereinafter, the beam coupling device 2 according to the present embodiment will be described by omitting the description of the same configuration and operation as the laser processing machine 1 and the beam coupling device 2 according to the first embodiment as appropriate.

FIG. 13 illustrates a configuration example of the BT 50A of the optical unit 4A in the second embodiment. The beam coupling device 2 of the present embodiment includes an optical unit 4A instead of the optical unit 4 of FIG. 8, in the same configuration as that of the first embodiment. For example, the optical unit 4A of the present embodiment includes the BT 50A of the configuration example of FIG. 13, instead of the BT 50 having the rotation angle θo in the optical unit 4 of the first embodiment. The BT 50A of the present embodiment has different pitches of the oblique lens portion 51 between the ±Z sides, that is, the emission side and the incident side of the light beam from the LD 31.

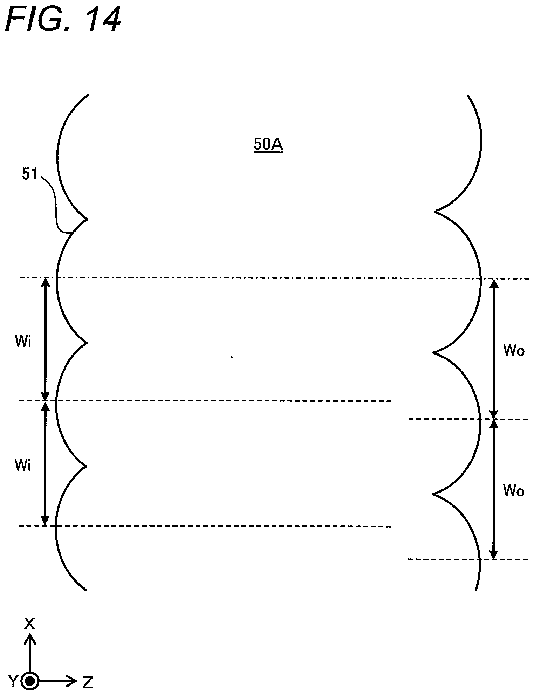

FIG. 14 illustrates a cross-sectional view of the XZ plane in the BT 50A of FIG. 13. The BT 50A of this configuration example is configured so that a pitch Wo between the oblique lens portions 51 on the surface on the +Z side is larger than a pitch Wi on the surface on the -Z side. The pitch Wi on the -Z side is set according to the pitch between the LDs 31 in the LD bar 3 as in the BT 50 of the first embodiment, for example. In the BT 50A of this configuration example, the center of the central oblique lens portion 51 matches on both sides of the ± Z side, for example. The curved surface shape of the oblique lens portion 51 on the surface on the +Z side can be set to extend the curved surface shape on the -Z side, for example.

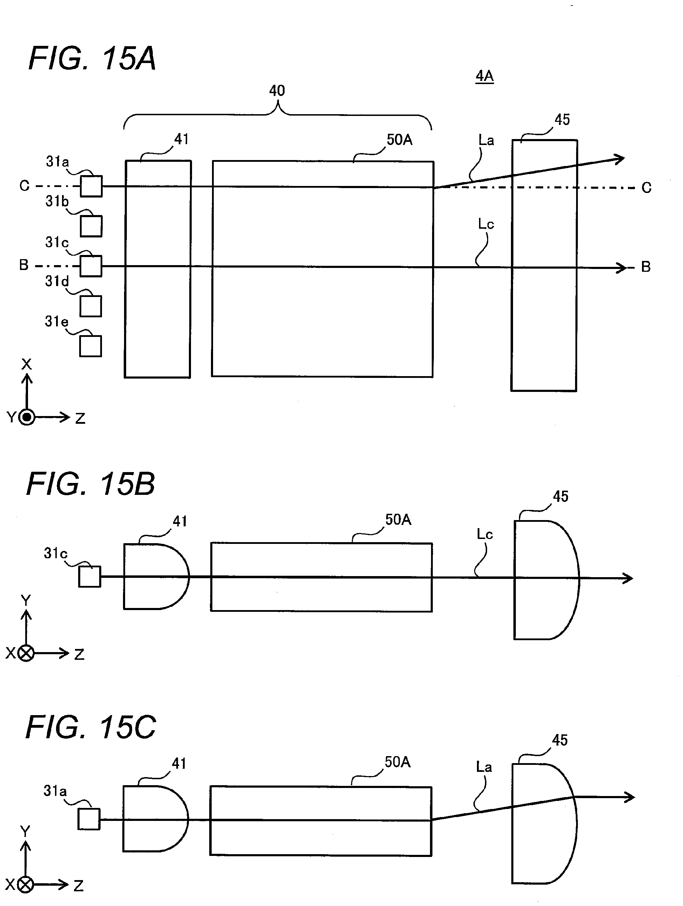

FIGS. 15A to 15C illustrate the optical path in the optical unit 4A of the present embodiment. FIG. 15A corresponds to a cross section similar to the cross section A-A in FIG. 8 in the optical unit 4A of the configuration example of FIG. 13. FIGS. 15B and 15C correspond to the B-B cross-sectional view and the C-C cross-sectional view in FIG. 15A, respectively. The BT 50A of the present embodiment is adjacent to the SAC 45 on the +Z side and adjacent to the FAC 41 on the -Z side, as in the first embodiment.

According to the optical unit 4A of the present embodiment, as illustrated in FIGS. 15A to 15C, the chief ray of the light beam from each LD 31, entering the FAC 41, goes straight along the Z direction to reach the +Z side surface of the BT 50A. On the +Z side surface of the BT 50A, the chief ray La is directed more outward in the X and Y directions as the LD 31a is located more outside in the X direction, according to the pitch Wo of the oblique lens portion 51 which is larger than that of the -Z side surface.

Each of chief rays La and Lc exits from the BT 50 to reach SAC 45. Here, as the SAC 45 collimates the light beam in the Y direction, the inclination of the chief ray Lc in the Y direction can be corrected in the SAC 45 as illustrated in FIG. 15C.

As described above, according to the optical unit 4A of the present embodiment, the chief ray Lc of the outer LD 31c in the X direction can be restricted to the X direction and directed outward.

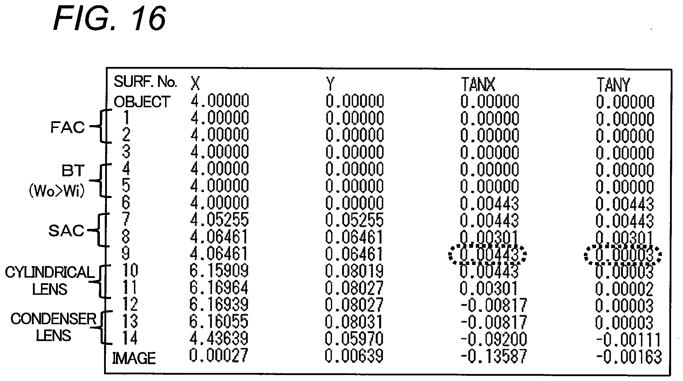

FIG. 16 illustrates the simulation results of the beam coupling device 2 of the second embodiment. In this simulation, the same numerical calculation as in the first embodiment was performed by setting that with "θo = 0", the pitch Wo on the +Z side of the BT 50A is made larger by 318 nm than the pitch Wi on the - Z side. The pitch between the pitch Wi on the -Z side of the BT 50A and the LD of the LD bar 3 was 0.225000 mm.

According to the simulation result of FIG. 16, as in FIG. 12, "TANX" was a positive value of "0.00443" after the exit of SAC 45, indicating that the chief ray on the +X side is directed outward. On the other hand, the value "0.00003" of "TANY" at this time was remarkably smaller than the example of FIG. 12. Therefore, according to the optical unit 4A of the present embodiment, it was checked that the outer chief ray in the X direction can be directed outward and the influence in the Y direction can be reduced as in the first embodiment.

As described above, in the beam coupling device 2 of the present embodiment, the optical unit 4A includes the BT 50A which is an example of the light emitter. The BT 50A includes a plurality of oblique lens portions 51, which are lens portions corresponding to the respective LDs 31 in the LD bar 3. In the BT 50A, the plurality of oblique lens portions 51 are arranged in the X direction to be inclined with respect to the Y direction. Among both sides of the BT 50A, the pitch Wo at which the plurality of oblique lens portions 51 are lined up on the +Z side surface to which the light beam from the LD 31 set is emitted is larger than the pitch Wi at which the plurality of oblique lens portions 51 are lined up on the -Z side surface on which the light beam is incident. According to the beam coupling device 2 of the present embodiment, the BT 50A can realize the directing outward of the outer chief ray La in the X direction as in the first embodiment.

### (Other Embodiments)

As described above, the first and second embodiments are described as an example of the technique disclosed in the present application. However, the technique in the present disclosure is not limited thereto, and can also be applied to embodiments in which changes, substitutions, additions, omissions, and the like are made as appropriate. In addition, it is also possible to combine each component described in each embodiment to form a new embodiment. Thus, in the following, other embodiments will be exemplified.

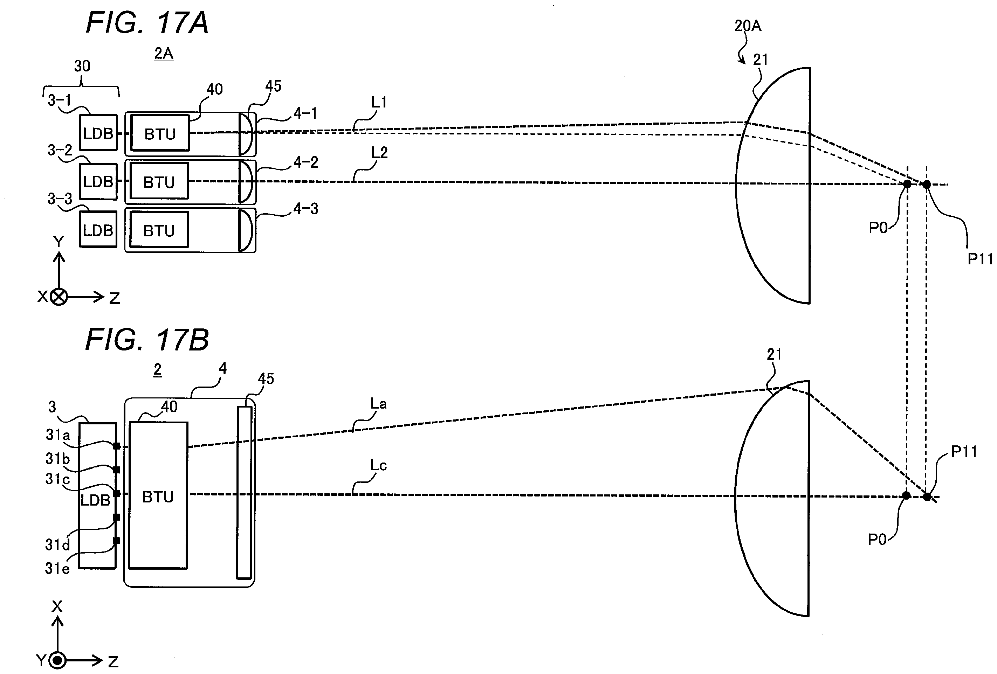

In the above first and second embodiments, the beam coupling device 2 for inwardly directing the outer chief ray L1 in the Y direction has been described. However, the chief ray L1 may not be inwardly directed, and may be outwardly directed, for example. This modification will be described with reference to FIGS. 17A and 17B.

FIGS. 17A and 17B illustrate the beam coupling device 2A in this modification. FIG. 17A and 17B illustrate a side view and a plan view of the beam coupling device 2A, respectively.

The beam coupling device 2A of this modification includes a coupling optical system 20A in which the cylindrical lens 22 is omitted in the same configuration as in FIGS. 2A and 2B. Further, in the beam coupling device 2A of this modification as illustrated in FIG. 17A, the outer optical unit 4-1 in the Y direction is configured to direct the chief ray L1 outward, instead of directing inward. For example, such an optical unit 4-1 can be realized by setting the shift width ΔY in FIG. 10 or the inclination angle θi in FIG. 11 to a negative value, that is, in the opposite direction thereof.

In the beam coupling device 2A of this modification, as illustrated in FIG. 17B, a beam coupling position can be set at the intersection position P11 between the chief rays La and Lc located on the +Z side from the focal position P0 of the condenser lens 21 as the coupling optical system 20A. In this case, by making the outer chief ray L1 in the Y direction directed outward without using the cylindrical lens 22, the beam coupling device P11 in the X and Y directions can be aligned as illustrated in FIGS. 17A and 17B, for example.

As described above, the embodiments are described as the exemplification of the technique in the present disclosure. To that end, the accompanying drawings and the detailed description are provided.

Therefore, among the components described in the accompanying drawings and the detailed description, not only the component essential for solving the problem, but also the component not essential for solving the problem may be included in order to exemplify the above technique. Therefore, it should not be certified that these non-essential components are essential immediately because these non-essential components are described in the accompanying drawings and the detailed description.

In addition, since the above embodiment is for illustrating the technique in the present disclosure, various changes, substitutions, additions, omissions, and the like can be made within the scope of the claims.

### INDUSTRIAL APPLICABILITY

The present disclosure is applicable to various applications in which a plurality of light beams are coupled and used, and is applicable to various laser processing techniques, for example.

## Claims

1. A beam coupling device (2) comprising:
a light source (30) that includes a plurality of light emitters (31) arranged as a set (3) of light emitters (31) in a first direction (X) and arranged as a plurality of sets (3) of light emitters (31) in a second direction, to emit a plurality of light beams having a light ray direction (La) from each of the light emitters (31), wherein the first direction (X) and the second direction (Y) intersect each other and the light ray direction (La) intersects the first and second directions;
a plurality of optical units (4-1 to 4-3) arranged to guide each light beam for each set (3) of light emitters (31) arranged in the first direction (X) in the light source (30); and
a coupling optical system (20) arranged to couple the plurality of light beams guided by each of the optical units, wherein
each of the optical units (4) is arranged to direct outward the light ray direction (La) of a first light beam among light beams emitted by the set (3) of light emitters (31), to guide the light beams from the set (3) of light emitters (31) into the coupling optical system (20), the first light beam being emitted by a light emitter that is located outside in the first direction (X) for the set (3) of light emitters (31).

2. The beam coupling device (2) according to claim 1, wherein
the coupling optical system (20) has a positive refractive power in the first direction (X) larger than a positive refractive power in the second direction, and
the plurality of optical units (4-1 to 4-3) are arranged to direct inward the light ray direction (La) of a second light beam emitted by a light emitter that is located outside in multiple light emitters (31) among the plurality of light emitters (31), the multiple light emitters (31) being arranged in the second direction (Y) in the light source.

3. The beam coupling device (2) according to claim 2, wherein the coupling optical system (20) includes an axially symmetric condenser lens (21) and a cylindrical lens (22) having a positive refractive power in the first direction.

4. The beam coupling device (2) according to claim 3, wherein the cylindrical lens (22) has a focal length shorter than a distance to the cylindrical lens (22) from a position at which an extension line (Ec) of an optical axis of the condenser lens (21) intersects another extension line (Ec) obtained by extending a chief ray (L1) from the optical unit toward the light source, the chief ray (L1) corresponding to the first light beam directed outward by the optical unit.

5. The beam coupling device (2) according to any one of claims 2 to 4, wherein
each optical unit includes a collimator lens arranged to collimate each light beam from the set (3) of light emitters (31) in the second direction (Y), and
in the plurality of optical units (4-1 to 4-3), the collimator lens of the optical unit located outside in the second direction (Y) is arranged at a position at which an incident light beam is directed inward.

6. The beam coupling device (2) according to any one of claims 2 to 4, wherein
among the plurality of optical units (4-1 to 4-3), the optical unit located outside in the second direction (Y) is arranged to direct inward orientation for emitting the light beam incident from the light source.

7. The beam coupling device (2) according to any one of claims 1 to 6, wherein
the optical unit includes a beam twister (50) unit arranged to rotate each light beam from the set (3) of light emitters (31), and
the beam twister (50) unit is arranged at a rotation angle with respect to the set (3) of the light emitters (31), the rotation angle directing outward the light ray direction (La) of the first light beam emitted by the light emitter located outside in the first direction.

8. The beam coupling device (2) according to any one of claims 1 to 6, wherein
the optical unit includes an optical element having a plurality of lens portions corresponding to each light emitter in the set (3) of light emitters (31),
in the optical element, the plurality of lens portions are arranged in the first direction (X) to be inclined with respect to the second direction, and
the optical element has both side surfaces with a pitch at which the plurality of lens portions are arranged in one surface from which the light beam from the set (3) of light emitters (31) is emitted being larger than a pitch in which the plurality of lens portions are arranged in another surface on which the light beam is incident.

9. A laser processing machine (1) comprising:
the beam coupling device (2) according to any one of claims 1 to 8; and
a processing head (11) arranged to irradiate a workpiece (15) with a light beam coupled by the beam coupling device.

## Patentansprüche

1. Strahlkopplungsvorrichtung (2), umfassend:
eine Lichtquelle (30), die eine Vielzahl von Lichtemittern (31) umfasst, die als eine Gruppe (3) von Lichtemittern (31) in einer ersten Richtung (X) angeordnet sind und als eine Vielzahl von Gruppen (3) von Lichtemittern (31) in einer zweiten Richtung angeordnet sind, um eine Vielzahl von Lichtstrahlen mit einer Lichtstrahlrichtung (La) von jedem der Lichtemitter (31) zu emittieren, wobei die erste Richtung (X) und die zweite Richtung (Y) einander schneiden und die Lichtstrahlrichtung (La) die erste und die zweite Richtung schneidet;
eine Vielzahl von Optikeinheiten (4-1 bis 4-3), die dazu eingerichtet sind, jeden Lichtstrahl bei jeder Gruppe (3) von Lichtemittern (31) zu führen, die in der ersten Richtung (X) in der Lichtquelle (30) angeordnet sind; und
ein optisches Kopplungssystem (20), das dazu eingerichtet ist, die Vielzahl von Lichtstrahlen zu koppeln, die von jeder der Optikeinheiten geführt werden, wobei
jede der Optikeinheiten (4) dazu eingerichtet ist, die Lichtstrahlrichtung (La) eines ersten Lichtstrahls unter den von der Gruppe (3) von Lichtemittern (31) emittierten Lichtstrahlen nach außen zu lenken, um die Lichtstrahlen von der Gruppe (3) von Lichtemittern (31) in das optische Kopplungssystem (20) zu leiten, wobei der erste Lichtstrahl von einem Lichtemitter emittiert wird, der sich außerhalb in der ersten Richtung (X) für die Gruppe (3) von Lichtemittern (31) befindet.

2. Strahlkopplungsvorrichtung (2) nach Anspruch 1, wobei
das optische Kopplungssystem (20) eine positive Brechkraft in der ersten Richtung (X) aufweist, die größer ist als eine positive Brechkraft in der zweiten Richtung, und
die Vielzahl von Optikeinheiten (4-1 bis 4-3) dazu eingerichtet ist, die Lichtstrahlrichtung (La) eines zweiten Lichtstrahls nach innen zu lenken, der von einem Lichtemitter emittiert wird, der sich außerhalb in mehreren Lichtemittern (31) unter der Vielzahl von Lichtemittern (31) befindet, wobei die mehreren Lichtemitter (31) in der zweiten Richtung (Y) in der Lichtquelle angeordnet sind.

3. Strahlkopplungsvorrichtung (2) nach Anspruch 2, wobei das optische Kopplungssystem (20) eine achsensymmetrische Kondensorlinse (21) und eine Zylinderlinse (22) mit einer positiven Brechkraft in der ersten Richtung umfasst.

4. Strahlkopplungsvorrichtung (2) nach Anspruch 3, wobei die Zylinderlinse (22) eine Brennweite aufweist, die kürzer ist als ein Abstand zu der Zylinderlinse (22) von einer Position, an der eine Verlängerungslinie (Ec) einer optischen Achse der Kondensorlinse (21) eine andere Verlängerungslinie (Ec) schneidet, die durch Verlängerung eines Hauptstrahls (L1) von der Optikeinheit in Richtung der Lichtquelle erhalten wird, wobei der Hauptstrahl (L1) dem ersten Lichtstrahl entspricht, der von der Optikeinheit nach außen gelenkt wird.

5. Strahlkopplungsvorrichtung (2) nach einem der Ansprüche 2 bis 4, wobei
jede Optikeinheit eine Kollimatorlinse umfasst, die dazu eingerichtet ist, jeden Lichtstrahl von der Gruppe (3) von Lichtemittern (31) in der zweiten Richtung (Y) zu kollimieren, und
in der Vielzahl von Optikeinheiten (4-1 bis 4-3) die Kollimatorlinse der Optikeinheit, die sich außerhalb in der zweiten Richtung (Y) befindet, an einer Position angeordnet ist, an der ein auftreffender Lichtstrahl nach innen gelenkt wird.

6. Strahlkopplungsvorrichtung (2) nach einem der Ansprüche 2 bis 4, wobei
unter der Vielzahl von Optikeinheiten (4-1 bis 4-3) die Optikeinheit, die sich außerhalb in der zweiten Richtung (Y) befindet, dazu eingerichtet ist, eine Orientierung nach innen zu lenken, um den von der Lichtquelle einfallenden Lichtstrahl zu emittieren.

7. Strahlkopplungsvorrichtung (2) nach einem der Ansprüche 1 bis 6, wobei
die Optikeinheit eine Strahldreher- (50) -Einheit umfasst, die dazu eingerichtet ist, jeden Lichtstrahl von der Gruppe (3) von Lichtemittern (31) zu drehen, und
die Strahldreher- (50) -Einheit in einem Drehwinkel bezogen auf die Gruppe (3) der Lichtemitter (31) angeordnet ist, wobei der Drehwinkel die Lichtstrahlrichtung (La) des ersten Lichtstrahls, der von dem außerhalb in der ersten Richtung befindlichen Lichtemitter emittiert wird, nach außen lenkt.

8. Strahlkopplungsvorrichtung (2) nach einem der Ansprüche 1 bis 6, wobei
die Optikeinheit ein optisches Element mit einer Vielzahl von Linsenabschnitten umfasst, die jedem Lichtemitter in der Gruppe (3) von Lichtemittern (31) entsprechen,
in dem optischen Element die Vielzahl von Linsenabschnitten in der ersten Richtung (X) derart angeordnet sind, dass sie gegenüber der zweiten Richtung geneigt sind, und
das optische Element auf beiden Seitenflächen einen Abstand aufweist, in dem die Vielzahl von Linsenabschnitten in einer Fläche, von der der Lichtstrahl von der Gruppe (3) von Lichtemittern (31) emittiert wird, angeordnet sind, der größer ist als ein Abstand, in dem die Vielzahl von Linsenabschnitten in einer anderen Fläche angeordnet sind, auf die der Lichtstrahl auftrifft.

9. Laserbearbeitungsmaschine (1), umfassend:
die Strahlkopplungsvorrichtung (2) nach einem der Ansprüche 1 bis 8; und
einen Bearbeitungskopf (11), der dazu eingerichtet ist, ein Werkstück (15) mit einem von der Strahlkopplungsvorrichtung gekoppelten Lichtstrahl zu bestrahlen.

## Revendications

1. Dispositif de couplage (2) de faisceaux comprenant :
une source de lumière (30) qui comprend une pluralité d'émetteurs de lumière (31) agencés sous la forme d'un ensemble (3) d'émetteurs de lumière (31) dans une première direction (X) et agencés sous la forme d'une pluralité d'ensembles (3) d'émetteurs de lumière (31) dans une seconde direction, destinée à émettre une pluralité de faisceaux lumineux présentant une direction de rayon lumineux (La) à partir de chacun des émetteurs de lumière (31), la première direction (X) et la seconde direction (Y) se croisant l'une l'autre et la direction de rayon lumineux (La) croisant les première et seconde directions ;
une pluralité d'unités optiques (4-1 à 4-3) agencées pour guider chaque faisceau lumineux pour chaque ensemble (3) d'émetteurs de lumière (31) agencés dans la première direction (X) dans la source de lumière (30) ; et
un système optique de couplage (20) agencé pour coupler la pluralité de faisceaux lumineux guidés par chacune des unités optiques,
chacune des unités optiques (4) étant agencée pour diriger vers l'extérieur la direction de rayon lumineux (La) d'un premier faisceau lumineux parmi des faisceaux lumineux émis par l'ensemble (3) d'émetteurs de lumière (31), pour guider les faisceaux lumineux provenant de l'ensemble (3) d'émetteurs de lumière (31) dans le système optique de couplage (20), le premier faisceau lumineux étant émis par un émetteur de lumière qui est situé à l'extérieur dans la première direction (X) pour l'ensemble (3) d'émetteurs de lumière (31).

2. Dispositif de couplage (2) de faisceaux selon la revendication 1,
le système optique de couplage (20) présentant une réfringence positive dans la première direction (X) supérieure à une réfringence positive dans la seconde direction et
la pluralité d'unités optiques (4-1 à 4-3) étant agencées pour diriger vers l'intérieur la direction de rayon lumineux (La) d'un second faisceau lumineux émis par un émetteur de lumière qui est situé à l'extérieur dans de multiples émetteurs de lumière (31) parmi la pluralité d'émetteurs de lumière (31), les multiples émetteurs de lumière (31) étant agencés dans la seconde direction (Y) dans la source de lumière.

3. Dispositif de couplage (2) de faisceaux selon la revendication 2, le système optique de couplage (20) comprenant une lentille de condenseur (21) axialement symétrique et une lentille cylindrique (22) présentant une réfringence positive dans la première direction.

4. Dispositif de couplage (2) de faisceaux selon la revendication 3, la lentille cylindrique (22) présentant une distance focale plus courte qu'une distance par rapport à la lentille cylindrique (22) à partir d'une position au niveau de laquelle une ligne d'extension (Ec) d'un axe optique de la lentille de condenseur (21) croise une autre ligne d'extension (Ec) obtenue par extension d'un rayon principal (L1) provenant de l'unité optique vers la source de lumière, le rayon principal (L1) correspondant au premier faisceau lumineux dirigé vers l'extérieur par l'unité optique.

5. Dispositif de couplage (2) de faisceaux selon l'une quelconque des revendications 2 à 4,
chaque unité optique comprenant une lentille de collimateur agencée pour collimater chaque faisceau lumineux provenant de l'ensemble (3) d'émetteurs de lumière (31) dans la seconde direction (Y) et
dans la pluralité d'unités optiques (4-1 à 4-3), la lentille de collimateur de l'unité optique située à l'extérieur dans la seconde direction (Y) étant agencée en une position au niveau de laquelle un faisceau lumineux incident est dirigé vers l'intérieur.

6. Dispositif de couplage (2) de faisceaux selon l'une quelconque des revendications 2 à 4, dans lequel
parmi la pluralité d'unités optiques (4-1 à 4-3), l'unité optique située à l'extérieur dans la seconde direction (Y) est agencée pour diriger une orientation vers l'intérieur afin d'émettre le faisceau lumineux incident provenant de la source de lumière.

7. Dispositif de couplage (2) de faisceaux selon l'une quelconque des revendications 1 à 6,
l'unité optique comprenant une unité de torsion (50) de faisceaux agencée pour faire tourner chaque faisceau lumineux provenant de l'ensemble (3) d'émetteurs de lumière (31) et
l'unité de torsion (50) de faisceau étant agencée à un angle de rotation par rapport à l'ensemble (3) des émetteurs de lumière (31), l'angle de rotation dirigeant vers l'extérieur la direction de rayon lumineux (La) du premier faisceau lumineux émis par l'émetteur de lumière situé à l'extérieur dans la première direction.

8. Dispositif de couplage (2) de faisceaux selon l'une quelconque des revendications 1 à 6,
l'unité optique comprenant un élément optique présentant une pluralité de parties de lentille correspondant à chaque émetteur de lumière dans l'ensemble (3) d'émetteurs de lumière (31),
dans l'élément optique, la pluralité de parties de lentille étant agencées dans la première direction (X) afin d'être inclinées par rapport à la seconde direction et
l'élément optique présentant les deux surfaces latérales avec un pas, auquel la pluralité de parties de lentille sont agencées dans une surface à partir de laquelle le faisceau lumineux provenant de l'ensemble (3) d'émetteurs de lumière (31) est émis, supérieur à un pas dans lequel la pluralité de parties de lentille sont agencées dans une autre surface sur laquelle le faisceau lumineux est incident.

9. Machine de traitement au laser (1) comprenant :
le dispositif de couplage (2) de faisceaux selon l'une quelconque des revendications 1 à 8 ; et
une tête de traitement (11) agencée pour soumettre une pièce (15) à un faisceau lumineux couplé par le dispositif de couplage de faisceaux.
